# FASCICULE DE BREVET EUROPEEN

(11) **EP 3 686 874 B1**
(45) Date de publication et mention de la délivrance du brevet: **06.10.2021**
(21) Numéro de dépôt: 20152670.4
(22) Date de dépôt: 20.01.2020
(51) Int. Cl.: G09G 3/20

(54) **SYSTÈME D'AFFICHAGE À RÉSOLUTION VARIABLE**
ANZEIGESYSTEM MIT VARIABLER AUFLÖSUNG
DISPLAY SYSTEM WITH VARIABLE RESOLUTION

(30) Priorité: 22.01.2019 FR 1900539
(43) Date de publication de la demande: 29.07.2020
(73) Titulaire: Commissariat à l'énergie atomique et aux énergies alternatives, 75015 Paris (FR)
(72) Inventeur: SEAUVE, Yoann, 38054 GRENOBLE CEDEX 09 (FR)
(74) Mandataire: Brevalex

(56) Documents cités:
- WO-A1-2018/035045
- US-A1- 2017 236 466
- US-B1- 6 191 770

## Description

### DOMAINE TECHNIQUE ET ÉTAT DE LA TECHNIQUE ANTÉRIEURE

La présente invention se rapporte au domaine des dispositifs d'affichages matriciels, également appelés écrans.

Dans ce domaine, on recherche généralement à augmenter la résolution, le taux de rafraîchissement, ainsi que le nombre de bits encodant une couleur affichée par chaque pixel, ce qui impose de transmettre à l'écran un flot de données de plus en plus conséquent.

Toutefois, pour certains dispositifs d'affichages ou certaines applications un flot de données trop important peut s'avérer pénalisant, notamment du fait de la consommation que la gestion de ce flot implique.

Des systèmes de compression de données conventionnels mettent en œuvre une suppression de redondance temporelle afin de fournir un flux de données compressé à un dispositif d'affichage. C'est le cas des systèmes utilisant par exemple un flot de données MPEG. Ce type de codage requiert l'emploi d'un décodeur dédié, qui peut s'avérer lui-même consommateur en énergie. Ce décodeur constitue généralement un composant distinct de l'écran. Des techniques basées sur l'emploi de dictionnaires de groupes de pixels associé à un codage entropique, une décomposition en odelettes ou combinant plusieurs méthodes de compression peuvent être également employées.

Il existe par ailleurs des dispositifs d'affichage qui sont eux-mêmes capables de produire une image avec une résolution diminuée et permettent la mise en œuvre d'une compression.

Un dispositif d'affichage à sélecteurs de lignes modifiés et configurés pour permettre de réaliser une diminution de la résolution d'affichage est présenté par exemple dans le document US7 532 190B2. Ce dispositif met en œuvre une réduction de résolution en sélectionnant simultanément plusieurs lignes afin que ces lignes reçoivent les mêmes données pixels. La réduction de résolution est réalisée, en suivant un axe vertical, de manière uniforme.

Le document WO201835045 présente quant à lui un dispositif à sélecteur de lignes et de colonnes adaptés pour mettre en œuvre 3 zones de résolutions différentes avec une zone centrale de plus haute résolution et des régions de résolution plus faible au fur et à mesure que l'on s'éloigne de la zone centrale. Différents blocs d'un sélecteur de colonnes permettent en particulier de modifier la résolution entre 3 résolutions différentes en fonction d'un code à 2 bits qui leur est soumis, les zones de pixels commandées par un même bloc fonctionnant à la même résolution.

Un tel dispositif manque de gamme de résolutions atteignables ainsi que de précision et de flexibilité en ce qui concerne le positionnement des zones de résolution différentes les unes par rapport aux autres.

Un dispositif similaire est dévoilé dans le document US 2017/236466 A1.

Il se pose le problème de trouver un nouveau dispositif d'affichage et qui soit amélioré vis-à-vis d'inconvénients mentionnés ci-dessus.

### EXPOSÉ DE L'INVENTION

Un mode de réalisation de la présente invention prévoit un dispositif d'affichage d'images tel que défini par la revendication 1.

Dans la première configuration, on propage un signal qui peut être un signal d'activation ou une donnée pixel tandis que dans la deuxième configuration on duplique le signal émis sur la voie de sortie précédente sur la voie de sortie donnée ce qui permet de dupliquer en conséquence sur une rangée (verticale pour une colonne ou horizontale pour une ligne) correspondant à la voie de sortie donnée, une donnée destinée à une rangée correspondant à la voie de sortie précédente.

Cette duplication permet de former des macro-pixels et de prévoir une réduction du flux de données pixels présenté à l'entrée du dispositif d'affichage. Une donnée destinée à un macro pixel est présentée une seule fois à l'entrée du dispositif d'affichage et est automatiquement dupliquée grâce à ce circuit de sélection par sélection simultanée de plusieurs lignes et/ou colonnes.

Ce dispositif permet, à l'aide d'une commande par mot de configuration, de créer des regroupements de lignes et/ou de colonnes, à la fois de tailles et de positions modulables tout en pouvant préserver de très faibles résolutions et une précision améliorée du positionnement de frontières entres zones de résolutions différentes, cette précision pouvant être obtenue au pixel près.

Selon un autre aspect, la présente demande concerne un procédé de gestion de données tel que défini par la revendication 9.

Des modes particuliers de réalisation de cette invention sont définis par les revendications dépendantes.

### BRÈVE DESCRIPTION DES DESSINS

La présente invention sera mieux comprise sur la base de la description qui va suivre et des dessins en annexe sur lesquels :
la Figure 1 sert à illustrer un exemple d'architecture d'un dispositif d'affichage tel que mis en œuvre suivant un mode de réalisation de la présente invention ;
la Figure 2 sert à illustrer un exemple de séquence de signaux mis en œuvre pour l'affichage d'une image formée de macro-pixels et susceptible d'être affichée par un dispositif tel que mis en œuvre suivant un mode de réalisation de l'invention ;
la Figure 3A sert à illustrer un exemple de réalisation particulier d'un sélecteur de lignes dans un dispositif d'affichage matriciel tel que mis en œuvre suivant un mode de réalisation de la présente invention ;
la Figure 3B sert à illustrer un exemple de réalisation particulier d'un sélecteur de colonnes dans un dispositif d'affichage matriciel tel que mis en œuvre suivant un mode de réalisation de la présente invention ;
la Figure 4 sert à illustrer un exemple d'architecture particulière de dispositif d'affichage dans laquelle le sélecteur de colonnes est dissocié d'une mémoire recevant les données pixels ;
la Figure 5 sert à illustrer un exemple de réalisation particulier de sélecteur de colonnes d'un dispositif d'affichage matriciel tel que mis en œuvre suivant un mode de réalisation de la présente invention et qui est apte à recevoir directement les données pixels ;
la Figure 6 sert à illustrer un premier exemple de délimitation en macro-pixels par un dispositif d'affichage suivant un mode de réalisation de la présente invention de sorte à réaliser un premier type de compression de données ;
la Figure 7 sert à illustrer un deuxième exemple de délimitation en macro-pixels par un dispositif d'affichage suivant un autre mode de réalisation de la présente invention de sorte à réaliser un deuxième type de compression de données ;
la Figure 8 sert à illustrer un troisième exemple de délimitation en macro-pixels par un dispositif d'affichage suivant un autre mode de réalisation de la présente invention de sorte à réaliser un troisième type de compression de données ;
la Figure 9 sert à illustrer un exemple de sélecteur de colonne d'un dispositif d'affichage suivant un mode de réalisation de la présente invention et permettant de fonctionner avec un flux de données pixels davantage compressé et reprenant le troisième type de compression de données ;
la Figure 10 sert à illustrer une variante de réalisation du sélecteur de colonnes et qui est apte à recevoir directement les données pixels ;
les Figures 11A-11C servent à illustrer une compression de données pixels mise en œuvre au moyen d'un dispositif d'affichage suivant l'invention sur une image comportant une zone d'intérêt et des régions d'intérêt moindre ;
la Figure 12 sert à illustrer une méthode de détermination de la localisation d'une zone d'intérêt dans une image que l'on peut afficher avec un dispositif d'affichage tel que mis en œuvre suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

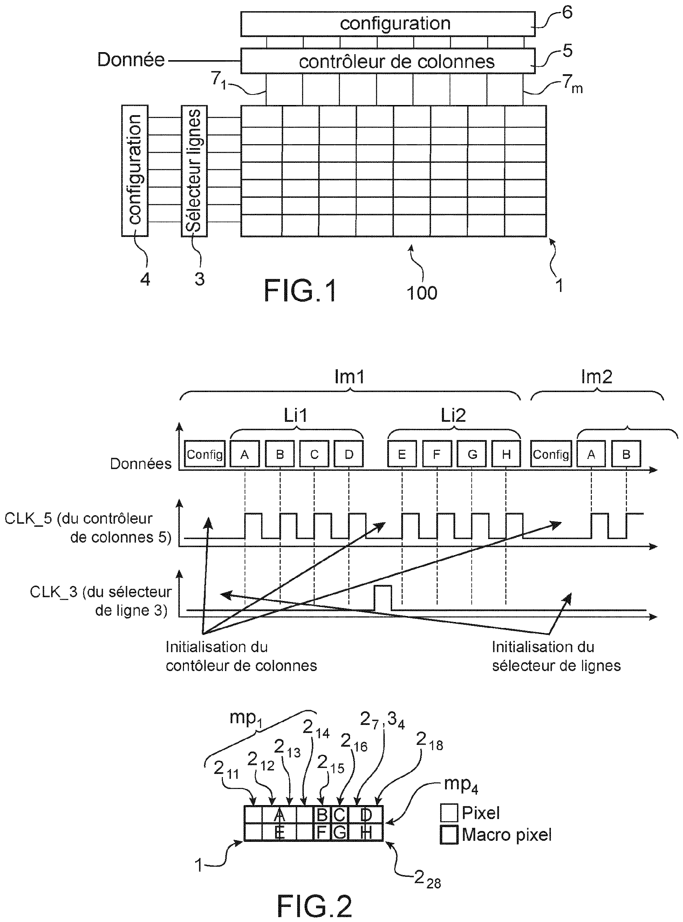

On se réfère à présent à la figure 1 donnant un exemple d'architecture générale d'un dispositif d'affichage tel que mis en œuvre suivant un mode de réalisation de la présente invention.

Ce dispositif est doté d'une matrice 1 de pixels 2 et est notamment apte à afficher des macro-pixels, autrement dit des ensembles de pixels voisins qui reçoivent une même donnée de contrôle d'affichage destinée à un pixel, (cette donnée étant encore appelée « donnée pixel ») et auxquels une même valeur de luminosité est par conséquent imposée, afin de réduire localement la résolution d'une ou plusieurs zones de l'image affichée, tout en conservant une résolution plus fine dans d'autres zones de l'image.

Lorsque le dispositif d'affichage est un écran couleur, une donnée pixel contient un ensemble de valeurs de luminosité distinctes pour chacune des couleurs. Au sein d'un macro-pixel ces ensembles de valeurs sont identiques d'un pixel à l'autre.

Les données pixel sont typiquement transmises à la matrice 1 ligne par ligne, en commençant de préférence par le pixel correspondant au coin supérieur gauche de la matrice. Les données correspondant à une même ligne sont dé-sérialisées par un contrôleur de colonnes 5 qui est couplé aux colonnes (rangées verticales) de la matrice 1 situé sur un bord de la matrice. Les données correspondant à une même ligne (rangée horizontale) sont communiquées simultanément aux pixels de la ligne correspondante.

À chaque transfert de données pixel entre le contrôleur de colonnes et la matrice de pixels, les données pixel sont envoyées sur des bus 7₁,...,7ₘ reliant les pixels d'une même colonne. Un sélecteur 3 de ligne est configuré pour sélectionner la ligne de pixels à laquelle sont destinées les données. Dans le cas où les données extérieures fournies sont de nature numérique, tandis que les pixels formant la matrice sont à commande analogique, le contrôleur 5 de colonnes peut contenir un ensemble de convertisseurs numérique analogique permettant de modifier la nature des données.

Le regroupement de pixels en macro-pixels a ici la particularité d'être réalisé à l'aide d'au moins un mot de configuration numérique formé d'un ensemble de bits dits de configuration, chacun des bits de configuration pouvant déterminer le regroupement de lignes ou colonnes adjacentes pour permettre à ces dernières de recevoir des données pixels identiques simultanément

La figure 2 sert à illustrer un regroupement de pixels en macro-pixels par un dispositif d'affichage mis en œuvre suivant un mode de réalisation de la présente invention. Le dispositif d'affichage est dans cet exemple prévu pour afficher une image Iml de 2 lignes de 8 pixels 2₁₁,..., 2₁₈, 2₂₁,..., 2₂₈.

Tout d'abord, au moins un mot de configuration (signal « config ») est reçu dans un registre d'un étage de commande de configuration du contrôleur 5 de colonnes.

Ensuite, des données de contrôle d'affichage des pixels d'une première ligne Lil, respectivement de valeur A, B, C, D sont transmises au contrôleur de colonnes 5 à chaque coup d'horloge (signal CLK_5) de ce contrôleur 5.

Du fait du mot de configuration reçu par l'étage de commande de configuration 6 associé au contrôleur 5 de colonne, le contrôleur de colonnes adopte une configuration lui permettant de dupliquer une donnée correspondant à une valeur A de luminosité destinée au premier pixel 2₁₁ simultanément sur plusieurs colonnes et pouvoir afficher des pixel 2₁₁, 2₁₂, 2₁₃, 2₁₄, de même luminosité formant un macro pixel mpi. Des données contenant respectivement les valeurs B, C et correspondant aux pixels 2₁₅, 2₁₆ ne sont pas dupliquées, tandis qu'une donnée suivante correspondant à une valeur D est dupliquée afin de former un macro-pixel mp₄.

Le sélecteur de lignes sélectionne ensuite (coup d'horloge CLK_3) une deuxième première ligne Li2, à laquelle des données de valeurs respectives E, F, G, H sont transmises de manière séquentielle.

Dans l'exemple de réalisation de la figure 2 un regroupement par colonnes est réalisé pour former des macro-pixels.

Pour réaliser des regroupements par lignes, l'architecture présentée sur la figure 1 peut fonctionner avec un mot de configuration LSW chargé dans un registre d'un étage 4 de commande de configuration couplé au sélecteur 3 de lignes.

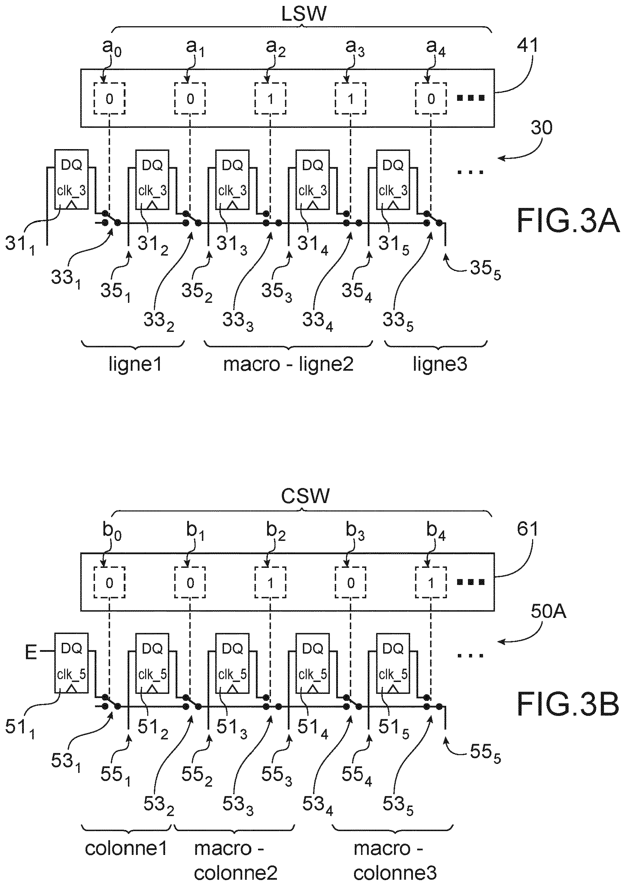

Pour réaliser une sélection simultanée de plusieurs lignes afin de présenter une même donnée pixel à des pixels de lignes différentes, le sélecteur de lignes peut être doté d'une architecture telle qu'illustrée sur la figure 3A.

Le sélecteur 3 de lignes est ici doté d'un bloc 30 de circuit comprenant une succession de registres à décalage 31₁,..,31ₖ, en particulier des registres 1 bit formés par exemple chacun d'une bascule D et recevant un même signal d'horloge CLK_3. Chacun des registres 31₁,..,31ₖ est associé à une voie de sortie du bloc 30 parmi une succession de voies 35₁,..,35ₖ de sortie.

Hormis la première voie 35₁ de sortie, chaque voie 35₂,..,35ₖ de sortie du bloc 30 est susceptible d'être connectée par le biais d'un commutateur 33₂,..,33ₖ, et en fonction de la configuration de ce commutateur, soit à une sortie Q du registre à décalage 31₂,..,31ₖ qui lui est associé, soit à la voie de sortie précédente dans ladite succession de voies de sorties 35₁,..,35ₖ. Les commutateurs 33₂,..,33ₖ, sont typiquement formés chacun d'un circuit à transistors. Hormis pour le premier registre 31₁, l'entrée de chaque registre à décalage 31₂,..,31ₖ est ici reliée à la voie de sortie associée au registre précédent de la succession de registres.

La configuration de chacun des commutateurs du bloc 30 est contrôlée individuellement par un bit a₀,...,aₖ₋₁ d'un ensemble de bits formant un mot de configuration LSW de sélecteur de ligne chargé dans un registre de configuration 41 de l'étage 4 de commande de configuration du sélecteur 3 de lignes.

Dans l'exemple de réalisation illustré, un bit a₁ prévu pour commander la configuration du commutateur 33₂ associé à la voie de sortie 35₂ est mis à une valeur logique par exemple '0'. Cela place le commutateur 33₂ dans une configuration où la voie de sortie 35₂ est reliée à la sortie Q du registre à décalage 31₂ qui est associé à cette voie de sortie 35₂. La voie de sortie 35₂ reliée à une sortie non inhibée du registre 31₂ prend alors, lors d'un cycle de l'horloge CLK_3, l'état qu'avait la voie de sortie précédente 35₁ au cycle d'horloge précédent. Une telle configuration peut permettre la propagation d'un signal par exemple d'activation dans la succession de registres.

Un autre bit a₂ prévu pour commander la configuration du commutateur 33₃ associé à la voie de sortie 35₃ est mis à une valeur logique différente, ici un '1', et permet de placer le commutateur 33₃ dans une configuration différente où la voie de sortie 35₃ est reliée cette fois à la voie de sortie 35₂ précédente. Dans cette autre configuration, le registre 31₃ associé à la voie de sortie 35₃ a cette fois une sortie que l'on dit « inhibée » et qui peut être laissée flottante. Cette sortie du registre 31₃ n'est cette fois pas connectée à sa voie de sortie 35₃ associée. Dans cette autre configuration où au moins deux voies de sorties sont reliées entre elles, on peut dupliquer une donnée pixel sur au moins deux lignes différentes et former ainsi une macro-ligne.

Dans l'exemple particulier illustré sur la figure 3A, les bits de configuration du mot LSW de configuration de sélecteur de lignes permettent de réaliser une duplication d'une donnée pixel sur 3 lignes (macro-ligne 2), en reliant les voie de sortie 35₂, 35₃, 35₄

Un tel dispositif permet d'obtenir une gestion flexible de la résolution selon un axe vertical de l'image dans la mesure où, outre la taille de regroupement de lignes, le positionnement de ce ou ces regroupements peut être ajusté bit à bit par le mot de configuration LSW.

L'activation des lignes ou macro-lignes dans lesquelles des données pixel sont chargées peut être réalisée par le biais d'un signal d'activation appelé « jeton » émis en entrée de la succession de registres 31₂,..,31ₖ et destiné à se propager dans le bloc 30, en suivant le principe du passage de jetons.

Le signal d'activation peut être tel qu'avant une arrivée de données destinées à la première ligne de la matrice un '1' d'activation est par exemple présenté à l'entrée de la succession de registres 31₂,..,31ₖ, tandis qu'un '0' est présenté pour les autres lignes.

Pour réaliser une activation de chaque nouvelle ligne d'une image compressée, un cycle horloge est reçu par le sélecteur 3 de lignes.

L'architecture du dispositif d'affichage illustrée sur la figure 1 prévoit avantageusement de pouvoir configurer à la fois le sélecteur 3 de lignes et le contrôleur 5 de colonnes.

En ce qui concerne l'architecture du contrôleur 5 de colonnes, on peut prévoir comme dans le mode de réalisation illustré sur la figure 3B, un contrôleur 5 muni d'un sélecteur de colonnes dont la structure reprend celle du sélecteur de lignes décrit précédemment.

Ainsi, le sélecteur de colonnes est ici formé d'un bloc 50A de circuit comprenant une succession de registres à décalage 51₁,..,51ₖ 1-bit chacun associé à une voie de sortie du bloc 50A parmi une succession de voies 55₁,..,55ₖ de sortie et chacun associé à un commutateur parmi une succession commutateurs 53₁,..,53ₖ. Les registres à décalage 51₁,..,51ₖ 1-bit sont cette fois commandés par un signal d'horloge CLK_5 différent du signal d'horloge permettant de cadencer le sélecteur de lignes.

Les commutateurs 53₁,..,53ₖ sont également contrôlés un à un cette fois par le biais d'un mot de configuration CSW de sélecteur de colonnes chargé dans un registre 61 d'un étage 6 de commande de configuration du contrôleur de colonnes et formé de bits b₀,...bₖ₋₁.

Dans l'exemple de réalisation illustré, un bit b₃ de commande de configuration du commutateur 53₄ associé à la voie de sortie 55₄ est mis à une valeur logique donnée, ici un '0', de sorte à mettre le commutateur 53₄ dans une configuration où il permet de relier la voie de sortie 55₄ à la sortie Q du registre à décalage 51₄ qui correspond à cette voie de sortie.

Un autre bit b₄ de commande de configuration du commutateur 53₅ associé à la voie de sortie 55s est mis à une valeur logique complémentaire de la valeur donnée, ici un '1' logique qui permet de mettre le commutateur 53s dans une configuration différente où il relie la voie de sortie 55s à la voie de sortie 55₄ précédente. Cette configuration où les voie de sortie 55₄, 55₅ permet de dupliquer une donnée de pixel sur deux colonnes différentes et former une macro-colonne (« macro-colonne 3 »).

Un tel dispositif permet d'obtenir une gestion flexible de la résolution selon un axe horizontal de l'image dans la mesure où, outre la taille de regroupement de colonnes, le positionnement de ce ou ces regroupements peut être ajusté bit à bit par le mot de configuration CSW.

Dans l'exemple de réalisation particulier de sélecteur de colonnes illustré sur la figure 3B, comme pour le sélecteur de lignes, c'est un signal d'activation qui est émis en entrée E de la succession de registres 51₂,..,51ₖ et qui destiné à se propager, en suivant le principe du passage de jetons et à être appliqué à une ou plusieurs voies de sorties.

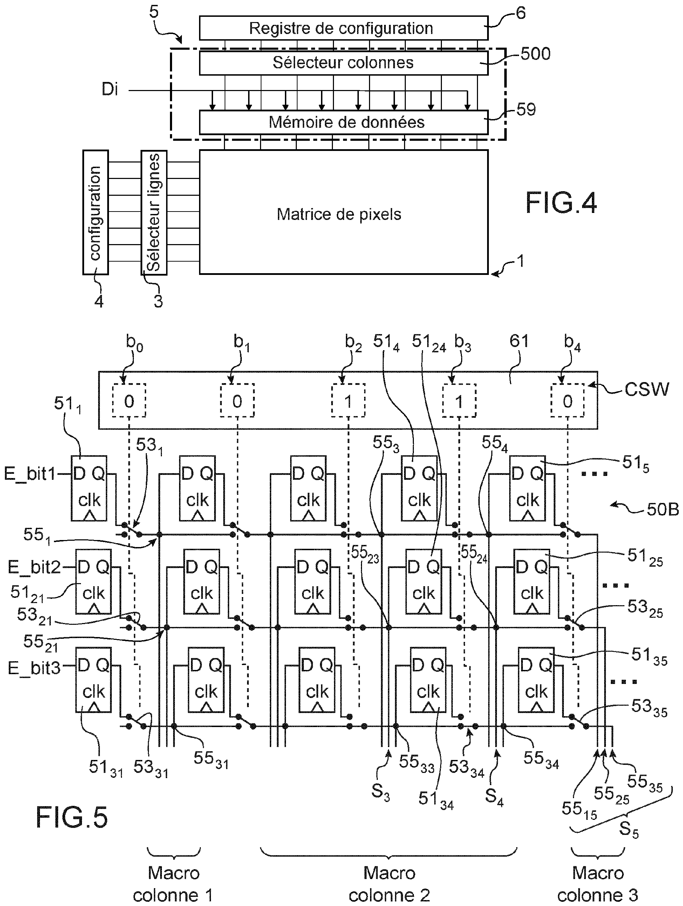

Dans ce cas, le contrôleur 5 de colonnes peut être prévu avec une architecture telle qu'illustrée de manière schématique sur la figure 4, avec un sélecteur de colonnes 500 reprenant l'agencement décrit précédemment en liaison avec la figure 3B et dont les voies de sorties sont couplées à une mémoire 59 destinée à recevoir des données pixel. Cette mémoire 59 est formée d'un ensemble d'espaces mémoire, chaque espace mémoire étant associé à une colonne parmi l'ensemble de colonnes de la matrice 1. Chaque espace mémoire est lui-même associé à une voie de sortie parmi l'ensemble des voies 55₁,..,55ₖ de sorties.

Chaque donnée pixel Di présentée à l'entrée du contrôleur 5 est ici présentée à l'entrée de tous les espaces mémoire de la mémoire 59. Seuls les espaces mémoires sélectionnés par le sélecteur de colonnes 500 mémorisent cette donnée Di. La sélection d'un espace mémoire ou de plusieurs espaces mémoire simultanément résulte elle-même de l'activation d'une voie de sortie (autrement dit de la réception par une voie de sortie d'un jeton d'activation) ou de plusieurs voies de sorties simultanément parmi les voies de sorties du sélecteur 500. Dans cet exemple de réalisation chaque voie de sortie du bloc 50A forme ainsi une sortie de sélection.

Selon une variante de réalisation, prévue en particulier dans le cas où les données pixel sont transmises sous forme numérique, un contrôleur de colonnes doté d'un bloc 50B dans lequel les fonctions de sélection et de mémorisation sont combinées peut être prévu.

Un exemple d'implémentation de ce type de contrôleur de colonnes est illustré sur la figure 5. Il comprend un circuit 50B doté d'un étage identique au circuit 50A décrit précédemment en lien avec la figure 3B, et qui est dupliqué pour chacun des N bits (avec N un entier qui peut être supérieur à 2) nécessaires à l'encodage d'une donnée pixel.

Chaque entrée du circuit 50B ne reçoit dans ce cas plus un signal d'activation sous forme d'un jeton de sélection mais un bit d'une donnée pixel.

Dans l'exemple de réalisation illustré où l'on prévoit par exemple N=3 entrées, en parallèle d'une première succession de registres 51₁, .... 51ₖ à décalage 1-bit, on prévoit une deuxième succession de registres à décalage 51₂₁,...,51₂ₖ, et une troisième succession de registres à décalage 51₃₁,...,51₃ₖ. En parallèle de chaque voie de sortie de la succession de voies 55₁,..., 55ₖ on prévoit N-l autres voies de sortie. Dans cet exemple où N=3, on a donc respectivement une voie de sortie prévue pour un premier bit de donnée pixel, une voie de sortie pour un deuxième bit de cette même donnée pixel, et une voie de sortie pour un troisième bit de cette même donnée pixel. Les voies de sorties 55₁, 55₂₁, 55₃₁..., 55ₖ, 55₂ₖ, 55₃ₖ forment des sorties de données par lesquelles des données pixels sont amenées à passer dans la mesure où un bit d'une donnée pixel émise en entrée E_bit2 et destinée à une voie de sortie 55₂₄ passe successivement par toutes les voies de sorties 55₂₁, 55₂₂, 55₂₃ situées entre cette entrée et la voie de sortie 55₂₄.

La succession de commutateurs 53₂₁, ..., 53₂ₖ en sortie respectivement des registres à décalage 51₂₁,...,51₂ₖ et la succession de commutateurs 53₃₁, ..., 53₃ₖ en sortie respectivement des registres à décalage 51₃₁,...,51₃ₖ est commandée par le même mot de configuration CSW que la succession de commutateurs 53₁, ..., 53ₖ.

Ainsi, dans l'exemple illustré, un bit de configuration b₃ du mot CSW mis par exemple à une valeur logique '1', permet de placer les commutateurs 53₄, 53₂₄, 53₃₄ dans une configuration dans laquelle les sorties Q respectives des bascules 51₄, 51₂₄, 51₃₄ sont inhibées. Ainsi, les voies de sortie 55₄, 55₂₄, 55₃₄, sont reliées respectivement aux voies de sortie 55₃, 55₂₃, 55₃₃, les précédant dans la succession de voies de sorties, ce qui permet de dupliquer les bits d'une donnée pixel sur plusieurs sorties S3, S4 de données correspondant chacune à une colonne de pixels de la matrice.

Les mots de configuration LSW, CSW destinés à configurer le sélecteur 3 de lignes et le contrôleur de colonnes 5 peuvent être transmis au dispositif d'affichage par un canal spécifique distinct de celui fournissant un signal vidéo correspondant à une séquence d'images. En variante, on peut incorporer ces mots de configuration dans le flux vidéo lui-même, par exemple sous forme de métas-données ou sous forme de « pixels de configuration » intégrés au flux vidéo. De tels pixels de configuration peuvent être des pixels rajoutés à l'image, par exemple en ajoutant une ligne spécifique de configuration en bordure, de préférence supérieure, d'une image à afficher. Une colonne spécifique en bordure latérale d'une image peut être également prévue. Cette ligne spécifique ou colonne spécifique n'est ensuite pas affichée. Ainsi, des champs d'un flux vidéo normalement destinés à la transmission des données de couleurs des pixels peuvent être utilisés pour transmettre les mots de configuration. Ce mode de transmission où les mots de configuration empruntent un format semblable aux données pixels permet de limiter le nombre de composants additionnels nécessaires à la gestion du signal vidéo.

Dans le cas où les tailles et positionnement des macros pixels restent inchangés d'une image à l'autre d'une séquence d'images, on peut prévoir de ne pas transmettre de mot de configuration et ne transmettre ainsi ces mots de configurations CSW, LSW que lorsqu'ils sont modifiés afin de redéfinir de nouveaux positionnements de macro-pixels sur une nouvelle image.

Les deux mots de configuration CSW, LSW peuvent être transmis aux registres 41, 61 avant l'envoi de chaque image d'une séquence d'images. Dans ce cas, un même mot de configuration CSW est employé pour toutes les lignes d'une image, l'image compressée transmise comportant alors le même nombre de pixels pour chacune de ses lignes. L'image compressée (autrement dit correspondant à un ensemble compressé de données pixels) transmise au dispositif d'affichage conserve alors un aspect « rectangulaire », dans la mesure où toutes les lignes correspondent au même nombre de données pixels, la même quantité de données pixel étant envoyée durant chaque temps ligne.

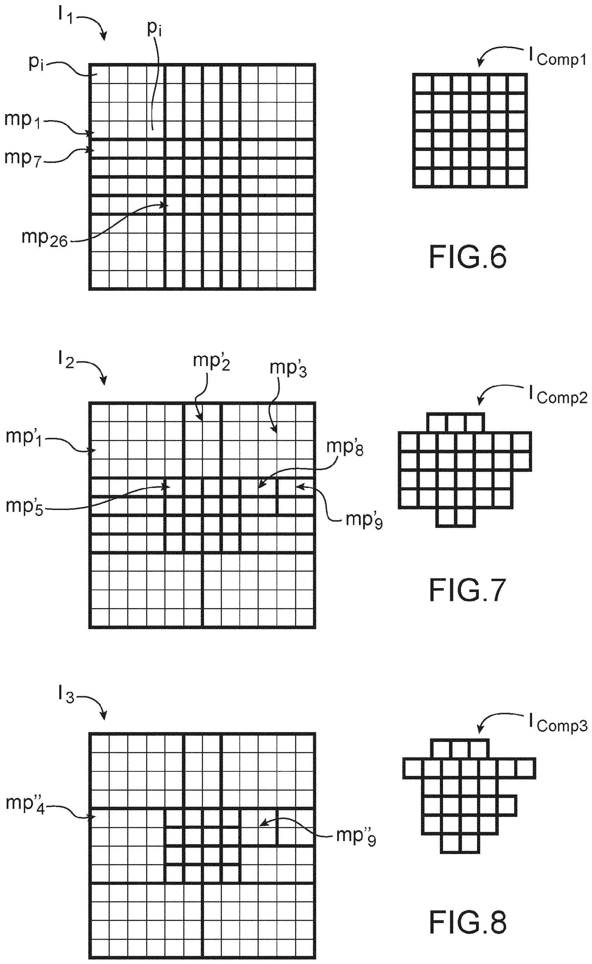

La Figure 6 illustre un exemple d'image I₁ affichée sur laquelle des macro-pixels mp₁,..., mp₇,..., mp₂₆,... (délimités par des bordures à trait épais) sont définis et correspondent à des groupes de pixels pᵢ (délimités par des bordures à trait fin) de même valeur construits à partir d'une image Icomp₁ compressée susceptible d'être reçue par un dispositif d'affichage tel que mis en œuvre suivant l'invention. Dans ce cas, le flux vidéo reçu par le dispositif d'affichage se rapproche d'un flux standard généralement prévu pour la transmission d'images rectangulaires. Il est également possible d'envoyer un nouveau mot de configuration LSW du sélecteur 3 de lignes avant chaque suite de données pixels correspondant à une nouvelle image d'une séquence d'images et d'envoyer un nouveau mot de configuration CSW pour le contrôleur 5 de colonnes avant chaque suite de données pixels correspondant à une nouvelle ligne de l'image. Cela peut imposer une transmission d'une quantité de mots de configuration plus importante que dans l'exemple décrit précédemment mais peut permettre, pour certains cas, d'atteindre des taux de compression plus élevés en diminuant la résolution horizontale au-dessus et en dessous d'une zone d'intérêt.

Un tel mode de transmission des mots de configuration peut impliquer une image compressée Icomp₂ d'aspect non-rectangulaire (quantité différente de données pixel envoyée durant chaque temps ligne) telle qu'illustrée par exemple sur la figure 7, donnant lieu à l'affichage d'une image I₂ formée de macro-pixels mp'₁, mp'₂, mp'₃..., mp'₅, mp'₈, mp'₉.

Avantageusement, lors de la transmission des mots de configuration LSW et CSW, on peut prévoir de ne pas transmettre de bit correspondant aux premier bits aoet b₀ de configuration de ces mots et ne transmettre ainsi que les bits suivants a₁...aₖ et b₁...bₖ. Les premiers bits a₀ et b₀ bits peuvent en effet être mis à une valeur par défaut dans la mesure où la première ligne ou la première colonne ne résulte pas d'une duplication d'une ligne ou colonne précédente.

Dans les exemples de réalisation décrits précédemment, on obtient l'affichage d'images avec une même résolution verticale en tout point d'une ligne de l'image. Or, dans certains cas, la résolution verticale ainsi imposée peut s'avérer plus importante que nécessaire de part et d'autre d'une zone d'intérêt. La figure 8 présente une image I3 qui résulte d'une image compressée Icomp3 comportant moins de pixels que l'image compressée Icomp2 de l'exemple précédent et dans laquelle le découpage en macro-pixels mp"4, mp"9 est tel que la résolution verticale évolue le long d'une ligne de l'image.

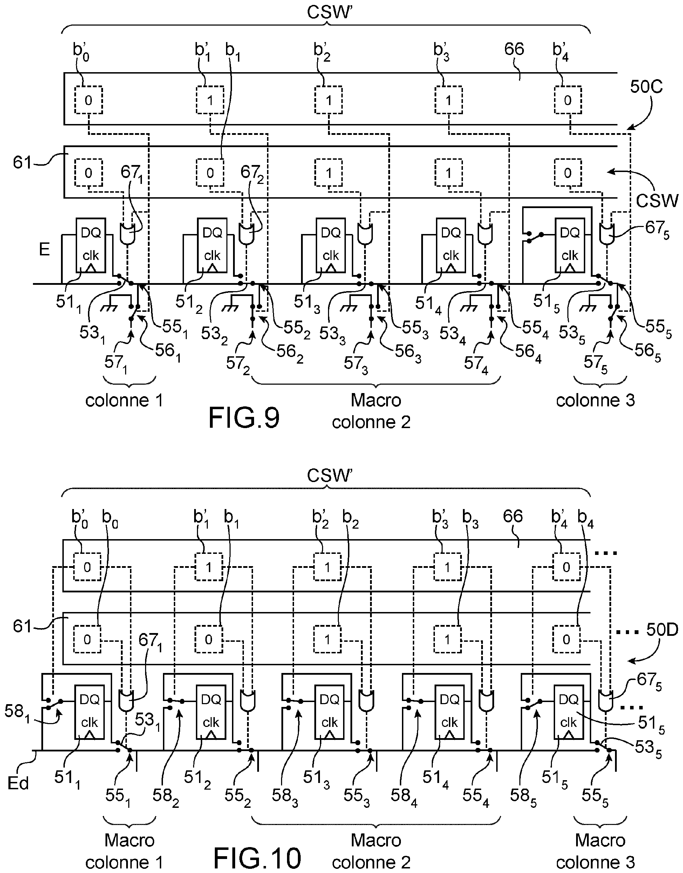

Un tel découpage peut être mis en œuvre à l'aide d'un autre exemple de sélecteur de colonnes tel qu'illustré sur la figure 9.

Le bloc 50C de sélection représenté s'adapte à une architecture telle que celle décrite précédemment en lien avec la figure 4, où l'on associe le sélecteur de colonnes à une mémoire de données et où ce sélecteur de colonnes reçoit en entrée un signal d'activation, en particulier de type jeton, tandis que les données pixel sont transmises à une mémoire ayant un fonctionnement tel que décrit précédemment et susceptible de mémoriser des données pixels à transmettre à la matrice en fonction du signal d'activation.

Dans ce bloc 50C de circuit, qui reprend la succession de registres à décalages 51₁,...,51ₖ et de commutateurs 53₁,...,53ₖ, la configuration des voies de sorties 55₁, ...., 55ₖ dépend cette fois en outre d'un second mot de configuration CSW' colonne introduit dans un deuxième registre 66 de l'étage 6 de commande de configuration.

Les voies 55₁,..., 55ₖ de sortie ne sont ici pas directement couplées aux éléments de mémorisation de la mémoire recevant des données pixels. Le circuit est cette fois couplé à la mémoire par l'intermédiaire de sorties de sélection 57₁, ..., 57ₖ. Les voies de sorties 55₁, ...., 55ₖ, ne sont susceptibles d'être couplées à la mémoire et d'activer des éléments de mémorisation associés que lorsqu'elles sont reliées à une sortie de sélection elle-même couplée à la mémoire. Des blocs de commutation intermédiaires 56₁,..., 56ₖ, sont ainsi prévus pour modifier l'agencement entre chaque voie de sortie 55₁, ...., 55ₖ, et sa sortie de sélection associée 57₁, ...., 57ₖ. De même que les commutateurs 53₁,...,53ₖ, chaque bloc de commutation 56₁,..., 56ₖ, peut être formé par exemple d'un circuit à transistors.

Le nouveau mot de configuration CSW' formé de bits b'₀...b'ₖ₋₁ permet d'empêcher un jeton déplacé par le sélecteur de colonne d'activer des sorties de sélection 57₁, ...., 57ₖ correspondant à des éléments mémoires pour lesquels le contenu en donnée pixel ne doit pas être mis à jour. De cette manière, il n'est pas nécessaire de fournir de données pixel pour des colonnes correspondant à des sorties de sélection désactivées par ce second mot de configuration CSW', ce qui peut permettre de réduire la quantité de données pixel nécessaire à l'affichage et de réaliser ainsi une compression accrue.

Les commutateurs 53₁,..., 53ₖ sont dans cet exemple chacun commandés par l'état d'un signal en sortie d'une porte logique 67₁,...67ₖ réalisant dans cet exemple une fonction logique OU. La configuration d'un commutateur donné est ainsi le résultat d'une fonction logique OU entre un bit de configuration du second mot de configuration CSW', et un bit de configuration du mot de configuration CSW. Dans l'exemple illustré, le bit b'₁=1 du mot CSW' et le b₁=0 du mot CSW mettent une sortie de la porte 67₂ à une valeur logique '1' permettant de placer le commutateur 53₂ dans une configuration dans laquelle, la voie de sortie 55₂ auquel il est associée est reliée à la voie de sortie 55₁ précédente. Une valeur logique complémentaire, par exemple un '0' logique, de la sortie de la porte 67₂ place le commutateur 53₂ dans une configuration différente, pour laquelle la voie de sortie 55₂ est reliée cette fois à la sortie Q du registre 51₂ associé à cette voie de sortie 55₂.

Chaque bloc de commutation 56₁,..., 56ₖ est quant à lui configuré pour : en fonction de la valeur d'un bit de configuration b'₀,...,bₖ₋₁ du second mot CSW', alternativement adopter soit, un premier état dans lequel ce bloc de commutation relie une voie de sortie 55₁,..., 55ₖ à laquelle il est associé à une sortie de sélection 57₁,..., 57ₖ soit un deuxième état dans lequel la voie de sortie 55₁,..., 55ₖ est déconnectée de la sortie de sélection 57₁,..., 57ₖ associée, cette dernière ne pouvant alors pas transmettre de signal à un autre étage du contrôleur 5 de colonnes et en particulier de jeton d'activation à la mémoire 59.

Une valeur donnée, dans cet exemple un '1' logique, d'un bit b'ₖ₋₂ du second mot CSW' met un bloc de commutation 56ₖ₋₁ dans le deuxième état, et le commutateur 53ₖ₋₁ associé dans une configuration dans laquelle sa voie de sortie associée 55ₖ₋₁ est reliée à une voie de sortie précédente 55ₖ₋₂, tandis qu'une valeur complémentaire (ici un '0' logique) de ladite valeur donnée du même bit de configuration b'ₖ₋₂ du second mot CSW' met le bloc de commutation 56ₖ₋₁ dans le premier état.

Dans l'exemple de réalisation illustré, le second mot de configuration CSW' permet d'inhiber certaines sorties de sélection 57₂, 57₃, et 57₄ en appliquant un '1' logique aux bits b'₁, b'₂, b'₃ permettant de commander respectivement les blocs de commutation 56₂, 56₃, et 56₄. Lorsqu'une sortie est inhibée, un signal d'activation tel qu'un jeton se traduisant par exemple par un '1' logique n'est alors pas communiqué à la mémoire 59 de données.

Bien que non représenté sur les figures 9 et 10, il est possible d'avoir le cas où b'ₖ₋₁ = 0 et bₖ₋₁ = 1, lorsqu'une nouvelle donnée est transmise à un macro-pixel comprenant au moins deux colonnes.

Cette configuration et celle des voies de sortie 55₂, 55₃, et 55₄, associées permet à un jeton en entrée E de passer directement en un unique cycle horloge à la voie de sortie 55₅.

Au niveau de la mémoire de données, les éléments mémoires correspondant à des sorties isolées ne mémorisent pas de nouvelle donnée, et peuvent conserver une donnée pixel utilisée pour une macro ligne précédente.

Le second mot de configuration CSW' peut être amené à être modifié pour chaque nouvelle macro ligne à afficher.

L'exemple de réalisation de la figure 9 prévoit une commande de la configuration des commutateurs 53₁,..., 53ₖ par le biais d'une fonction logique OU. On peut prévoir de réaliser cette commande par le biais d'autres fonctions logiques, par exemple de sa fonction logique complémentaire (NON OU), ou par exemple d'une fonction NON ET ou bien de sa complémentaire (ET). La fonction utilisée pour obtenir le comportement souhaité peut dépendre de la correspondance choisie entre la polarité des bits de configuration et l'état des différents commutateurs.

Une variante de réalisation du sélecteur de colonnes décrit précédemment et permettant d'assurer une fonctionnalité similaire à celle du circuit donné sur la figure 9, est illustrée sur figure 10.

Elle concerne cette fois un cas dans lequel des données pixel sont émises en entrée Ed du sélecteur de colonnes. Dans cet exemple, les voies de sorties 55₁,..., 55ₖ d'un bloc 50D de circuit de sélection forment ainsi des sorties de données pixel. L'exemple de réalisation illustré correspond à des données pixels codées sur 1 bit. Dans le cas où l'on prévoit des données sur plusieurs bits on met en parallèle plusieurs circuits tel que celui représenté, chaque entrée et chaque voie de sortie correspondant dans ce cas à un bit de donnée pixel.

Le bloc 50D de circuit de sélection illustré reprend la succession de registres à décalages 51₁,...,51ₖ, de commutateurs 53₁,...,53ₖ, ainsi que les registres 61, 66, de stockage respectivement du premier mot de configuration CSW et du second mot de configuration CSW' et les portes logiques 67₁,..., 67ₖ de commande des commutateurs 53₁,..., 53ₖ.

Les commutateurs 53₁,..., 53ₖ sont dans cet exemple également chacun commandés par l'état d'un signal en sortie d'une porte logique 67₁,...67ₖ réalisant dans cet exemple une fonction logique OU. La configuration d'un commutateur donné est ainsi le résultat d'une fonction logique OU entre un bit de configuration du second mot de configuration CSW', et un bit de configuration du mot de configuration CSW.

Les bits du second mot de configuration CSW' permettent cette fois de contrôler l'état un à un d'éléments de commutation 58₁,..., 58ₖ associés respectivement aux bascules 51₁,..., 51ₖ. Les éléments de commutation 58₁,..., 58ₖ sont par exemple formés chacun de circuit à transistors. Chaque élément de commutation 58₁,..., 58ₖ est configuré pour, en fonction de la valeur d'un bit de configuration du second mot CSW', alternativement adopter un premier état dans lequel il relie une sortie Q d'un registre 51₁,..., 51ₖ en entrée duquel il se situe à une entrée D de ce registre, et un deuxième état dans lequel la sortie Q est cette fois déconnectée de l'entrée D. Dans cet exemple de réalisation particulier, une valeur donnée, dans cet exemple un '1' logique, d'un bit b'₀ du second mot CSW' met un élément de commutation 58₁ dans le premier état, tandis qu'une valeur complémentaire (ici un '0' logique) du même bit de configuration b'₀ du second mot CSW' place le bloc de commutation 58₁ dans le deuxième état.

Lorsqu'un élément de commutation 58ₖ se trouve dans le deuxième état, l'entrée du registre associé peut-être, pour les registres suivant le premier registre 51₁, connectée à une voie de sortie précédente, c'est à dire associée à un registre précédent, en particulier lorsqu'un commutateur 53₁,...,53ₖ associé à cette voie de sortie précédente est connecté à la sortie du registre précédent.

Une valeur donnée, dans cet exemple un '0' logique, d'un bit b'ₖ₋₂ du second mot CSW' met un bloc de commutation 58ₖ₋₁ dans le deuxième état, tandis qu'une valeur complémentaire (ici un '1' logique) de ladite valeur donnée du même bit de configuration b'ₖ₋₂ du second mot CSW' met le bloc de commutation 58ₖ₋₁ dans le premier état.

Ainsi, dans l'exemple de réalisation illustré, un élément de commutation 58₂ associé à un registre 51₂ est mis, par le biais d'un bit b'₁ du deuxième mot de configuration CSW' dans le premier état. L'entrée D du registre à décalage 51₂ auquel l'élément de commutation 58₂ est associé étant reliée à la sortie Q de ce même registre 51₂, ce registre 51₂ conservant ainsi en sortie le même état. Un élément de commutation 58₅ associé à une bascule 51₅ est mis, par le biais d'un autre bit b'₄ du deuxième mot de configuration CSW' dans le deuxième état. L'entrée D du registre à décalage 51s auquel il est associé est connecté à la voie de sortie 55₄ associée au registre à décalage 51₄ précédent.

L'action des bits du deuxième mot de configuration CSW' sur les portes logiques 67₁,..., 67ₖ est conservée durant la réception des données pixel.

Cette action peut être neutralisée avant un transfert de données du contrôleur de colonnes à la matrice de pixels.

Sur la figure 10, le bloc 50D de circuit de sélection du contrôleur de colonnes est représenté dans une configuration correspondant à une phase de réception de données. Dans la configuration particulière illustrée, les registres 51₁ et 51s permettent de recevoir de nouvelles données à destination de macros colonnes 1 et 3, tandis que le registre 51₂ conserve une donnée déjà présentée à une macro colonne 2, pour une ligne précédente de la matrice.

Lors d'une phase de transfert (non représentée) des données à la matrice, on impose alors au commutateur 53₂, dans cet exemple par le biais d'un '0' logique sur le bit b₁, un état dans lequel la voie de sortie de sortie 55₂, auquel il est associé est reliée en sortie Q du registre 51₂. Le deuxième mot de configuration CSW' ne sert alors plus lors de cette phase à commander les commutateurs 55₁,...,55ₖ. La neutralisation de l'effet du deuxième mot de configuration CSW' permet alors à la macro colonne 2 de recevoir la donnée qui a été conservée par le registre 51₂ durant la phase de réception des données. Une manière de neutraliser l'effet du deuxième mot de configuration CSW', est d'imposer une même valeur logique à tous ses bits b'₀,...,b'ₖ₋₁, en particulier lorsque les portes logiques 67₁,...67ₖ sont de type OU, ou d'implémenter la fonction de neutralisation dans la fonction logique qui commande les commutateurs 55₁ - 55ₖ afin de commander cette neutralisation par un unique signal plutôt que par la modification de tous les bits de CSW'.

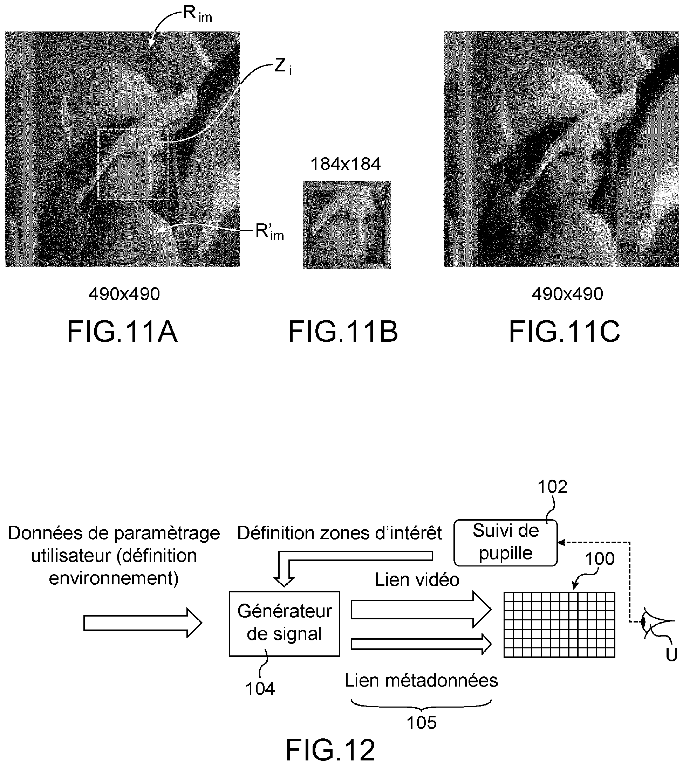

Les figures 11A-11C illustrent un principe de compression décompression d'images à afficher par un écran tel que décrit précédemment.

Sur ces figures sont respectivement représentées : une image à afficher comprenant une zone d'intérêt (figure 11A), une image (figure 11B) telle que transmise au dispositif d'affichage mis en œuvre suivant l'invention et dont les pixels correspondent à des macro-pixels d'une image destinée à être affichée selon un découpage en macro-pixels tel qu'illustré sur la figure 6, et une image reconstituée (figure 13C) susceptible d'être affichée par l'écran du dispositif d'affichage tel que mis en œuvre suivant l'invention.

L'image à afficher comporte une zone d'intérêt Zi pour laquelle on souhaite conserver une résolution plus importante, dans cet exemple dont on souhaite conserver la résolution initiale ainsi qu'une ou plusieurs régions d'intérêt moindre Rim, R'im. Les régions Rim, R'im sont prévues avec une résolution moindre par exemple divisée par 10. Dans cet exemple particulier l'affichage d'une image d'une résolution initiale de 490 x 490 pixels ne requière la transmission à l'écran que d'une image compressée de 184 x 184 pixels, soit environ 7 fois moins de données pixels. On prévoit d'ajouter à cette image compressée des bits de configuration nécessaires, dans cet exemple 490+490= 980 bits pour définir les macro-pixels au niveau de l'écran. Si l'on considère qu'une couleur d'un pixel est codée sur 24 bits à raison de 8 bits par canal Rouge, Vert, Bleu, la quantité totale de données transmises à l'écran est de 184 x 184 x 24 + 980 = 813 524 bits.

La transmission de l'image originale sans compression aurait nécessité 490 x 490 x 24 = 5 762 400 bits, soit environ 7 fois plus. La présence des mots de configuration dans la totalité de données à traiter n'est pas significative et s'avère ici négligeable devant la quantité de données nécessaires à la description de l'image à afficher.

Le dispositif d'affichage peut également trouver des applications par exemple dans un système de réalité augmentée où un dispositif informatique muni d'au moins un processeur superpose en temps réel des éléments d'images 2D, 3D, vidéos à des images réelles.

Le dispositif d'affichage peut également trouver des applications dans les systèmes de réalité virtuelle où un dispositif informatique muni d'au moins un processeur génère en temps réel des d'images 2D, 3D, vidéos artificielles.

La figure 12 représente schématiquement un système informatique de réalité virtuelle ou de réalité augmentée utilisant un dispositif d'affichage 100 à résolution variable tel que décrit précédemment.

Ce système muni d'au moins un processeur de données ou d'un ordinateur comporte un bloc de génération 104 de signal dont le rôle est de générer une image destinée à être affichée par un écran du dispositif d'affichage. Ce bloc 104 est apte à recevoir des données de paramétrage permettant de définir l'environnement qui sera présenté à un utilisateur U au travers de l'écran. Ce bloc 104 est également destiné à recevoir des données permettant de définir une ou des zones d'intérêt sur l'écran afin de générer un signal vidéo compressé permettant d'afficher des régions d'intérêt moindre en plus basse résolution que la zone d'intérêt. Le bloc 104 peut être réalisé par exemple par un circuit intégré de type processeur graphique (GPU) programmé pour générer le signal de commande de l'écran à partir d'une description numérique d'une scène à rendre et d'une ou plusieurs zones d'intérêt.

Une image destinée au dispositif d'affichage 100 peut être générée de manière conventionnelle, puis compressée dans ce bloc de génération 104 de signal au moyen d'une étape de traitement ultérieur. Il est également possible de prévoir un bloc 104 apte à générer nativement une image sous forme compressée. Cela évite de générer un rendu en haute définition dans une région où la résolution est amenée à être dégradée ultérieurement. Le bloc de génération 104 d'image peut être par la suite transmis à l'écran sous forme compressée grâce à un lien de transmission 105 assurant à la fois le transport du signal vidéo et des mots de configuration. L'exemple de réalisation illustré sur la figure 12 prévoit un lien 105 dédié au transport du seul signal vidéo en utilisant un lien séparé 106 pour l'acheminement des mots de configuration. Les données permettant de définir les zones d'intérêt de l'écran peuvent être extrapolées par le bloc 104 grâce à une estimation de l'intérêt de chaque partie de la scène rendue. Il est possible d'obtenir ces informations par le biais d'un système 102 de suivi des pupilles d'un utilisateur U. Le système 102 de suivi des pupilles peut être par exemple un système tel qu'utilisé par exemple dans le document de Li and W. G. Wee, "An efficient method for eye tracking and eye-gazed FOV estimation" 2009 16th IEEE International Conference on Image Processing (ICIP), Cairo, 2009, pp. 2597-2600. doi: 10.1109/ICIP.2009.5413997.

Cela permet de définir comme zone d'intérêt une partie de l'écran sur laquelle l'utilisateur U est focalisé.

Il est également possible en variante de prévoir un bloc générateur de signaux qui réalise seulement une étape de conversion, par exemple en recevant lui-même un flux vidéo encodé dans un format classique et en générant le signal compressé et les mots de configurations attendus pas l'écran à résolution variable.

## Revendications

1. Dispositif d'affichage d'images comprenant une matrice de pixels agencés en formant plusieurs lignes et plusieurs colonnes de pixels, le dispositif d'affichage comprenant :
- un sélecteur de lignes (3), couplé aux lignes de la matrice de pixels,
- un contrôleur de colonnes (5) couplé aux colonnes de la matrice de pixels,
le sélecteur (3) de lignes et/ou le contrôleur de colonnes (5) comprenant :
- un circuit de sélection (30, 50A, 50B, 50C, 50D) comportant une succession de voies de sorties (35₁,...,35ₖ; 55₁,...,55ₖ,) correspondant à différentes rangées de ladite matrice de pixels, ledit circuit de sélection comprenant en outre une succession de registres (31₁,...,31ₖ ; 51₁,...,51ₖ) à décalage et une succession de commutateurs (33₁,..., 33ₖ ; 53₁,..., 53ₖ) commandée par au moins un mot de configuration (LSW, CSW, CSW'), chaque registre à décalage étant associé à une voie de sortie dudit circuit de sélection et à un commutateur de ladite succession de commutateurs (33₁,..., 33ₖ ; 53₁,..., 53ₖ),
une voie de sortie donnée (35₃, 55₃) dudit circuit de sélection étant connectée à une entrée d'un registre à décalage suivant (31₄, 51₄) le registre à décalage (31₃, 51₃) auquel la voie de sortie donnée (35₃, 55₃) est associée,
cette voie de sortie donnée (35₃, 55₃) étant connectée à une sortie du registre à décalage auquel elle est associée et déconnectée d'une voie de sortie précédente (35₂, 55₂) de ladite succession de voies de sorties lorsque le commutateur donné (33₂, 53₂) auquel cette voie donnée de sortie est associée est mis dans une première configuration, la voie de sortie donnée (35₃, 55₃) étant connectée à ladite voie de sortie précédente (35₂, 55₂) de ladite succession de voies de sorties et déconnectée de ladite sortie du registre à décalage auquel ladite voie de sortie est associée lorsque le commutateur donné (33₃, 53₃) est mis dans une deuxième configuration, le dispositif comprenant en outre :
- un étage (4, 6) de commande, pour commander les configurations respectives de la succession de commutateurs (33₁,..., 33ₖ ; 53₁,..., 53ₖ) dudit circuit de sélection (30, 50A, 50B, 50C, 50D), l'étage de commande (4, 6) étant doté d'au moins un registre mémoire (41, 61, 66) pour recevoir au moins un mot de configuration (LSW, CSW, CSW') et étant configuré pour mettre les commutateurs (33₁,..., 33ₖ ; 53₁,..., 53ₖ) de ladite succession de commutateurs respectivement dans l'une desdites première configuration ou deuxième configuration en fonction des états respectifs de bits (a₀,...,aₖ₋₁ ; b₀,...,bₖ₋₁) dudit mot de configuration (LSW, CSW, CSW'), de sorte qu'une configuration d'un premier commutateur dépend d'une valeur d'un premier bit dudit mot de configuration, une configuration d'un deuxième commutateur dépendant d'une valeur d'un deuxième bit dudit mot de configuration.

2. Dispositif (100) d'affichage selon la revendication 1, dans lequel ledit circuit de sélection (50A) appartient au contrôleur (5) de colonnes, le contrôleur de colonnes comprenant un sélecteur (500) de colonnes doté dudit circuit (50A) de sélection et dans lequel un jeton d'activation est apte à être émis en entrée (E) de ladite succession de registres (51₁,...,51ₖ) et à se propager dans cette succession pour séquentiellement activer une voie de sortie ou concomitamment un groupe de voies de sorties connectées entre elles, le contrôleur (5) de colonnes comprenant en outre, en sortie dudit sélecteur de colonnes : une mémoire (59), ladite mémoire (59) étant configurée pour recevoir une séquence de données de contrôle d'affichage de pixel et étant dotée d'une pluralité d'espaces mémoire associés chacun à une colonne parmi lesdites colonnes de la matrice, chaque espace mémoire étant lui-même associé à une voie de sortie (53₁,..., 53ₖ) dudit circuit de sélection (50) qui, lorsqu'elle est activée, provoque, consécutivement à la réception d'une donnée de contrôle d'affichage en entrée de la mémoire, une mémorisation de cette donnée dans le ou les espace(s) mémoire(s) associé(s) respectivement à la ou les voies de sortie (53₁,..., 53ₖ) activées.

3. Dispositif (100) d'affichage selon la revendication 1, dans lequel ledit circuit de sélection (50B) appartient au contrôleur (5) de colonnes, ledit circuit de sélection (50B) étant configuré pour recevoir des données de contrôle d'affichage de pixel codées sur N bits (avec N≥1), ladite voie de sortie donnée (55₃) de ladite succession de voies de sortie (55₁,...,55ₖ) étant une voie de sortie d'un bit d'une donnée de contrôle d'affichage de pixel.

4. Dispositif (100) d'affichage selon la revendication 3, dans lequel le circuit de sélection (50B) est configuré pour recevoir des données de contrôle d'affichage de pixel codées sur N bits (avec N >2), ledit circuit de sélection (50B) étant configuré de sorte qu'un premier bit de donnée de contrôle d'affichage de pixel est émis sur une première entrée (E_bit1) dudit circuit de sélection (50B) correspondant à une entrée de ladite succession (51₁,...,51ₖ) de registres à décalage,
ledit circuit de sélection (50B) comprenant en outre, en parallèle de ladite succession de registres (51₁,...,51ₖ) à décalage, au moins une deuxième succession de registres à décalage (51₂₁,...,51₂ₖ), chaque registre à décalage de ladite deuxième succession étant associé à une voie de sortie de sélection d'une deuxième succession de voies de sortie (55₂₁, ...,55₂ₖ) et à un commutateur d'une deuxième succession de commutateurs (53₂₁,...,53₂ₖ), ledit circuit de sélection (50B) étant configuré de sorte qu'un deuxième bit de donnée de contrôle d'affichage de pixel est émis sur une deuxième entrée (E_bit2) dudit circuit de sélection (50B) correspondant à une entrée (E_bit2) de ladite deuxième succession (51₂₁,...,51₂ₖ) de registres à décalage,
ladite voie de sortie donnée (55₃) de ladite succession de voies de sortie (55₁,...,55ₖ) et une autre voie de sortie (55₂₃) de la deuxième succession de voies de sortie (55₂₁,...,55₂ₖ), étant des voies de sortie respectivement d'un bit d'une donnée de contrôle d'affichage de pixel et d'un autre bit de ladite même donnée de contrôle d'affichage dudit pixel à destination d'une colonne de la matrice, ladite autre voie de sortie (55₂₃) étant associée à un commutateur (53₂₃) de ladite deuxième succession de commutateurs commandé par un même bit de configuration (b₂) dudit mot de configuration (CSW) que ledit commutateur donné (53₂).

5. Dispositif (100) d'affichage selon la revendication 1, dans lequel ledit circuit de sélection (50B) appartient au contrôleur (5) de colonnes et dans lequel ledit étage (6) de commande de configuration est configuré pour recevoir au moins un autre mot de configuration (CSW'), ledit étage de commande (6) de configuration étant doté d'une suite de portes logiques (67₁,...67ₖ) dont les sorties respectives contrôlent les configurations respectives desdits commutateurs (53₁,..., 53ₖ) de ladite succession de commutateurs et de sorte que les configurations respectives desdits commutateurs (53₁,..., 53ₖ) sont le résultat d'une fonction logique, en particulier une fonction OU ou une fonction NON ET, entre un bit de configuration (b₀,...,bₖ) dudit mot de configuration (CSW), et un bit de configuration (b'₀,...,b'ₖ) dudit autre mot de configuration (CSW').

6. Dispositif (100) d'affichage selon la revendication 5, dans lequel ledit circuit de sélection (50C) appartient au contrôleur (5) de colonnes, le contrôleur de colonnes (5) comprenant un sélecteur (500) de colonnes comportant une succession de sorties de sélections (57₁,..., 57ₖ), le sélecteur de colonnes étant doté dudit circuit (50C) de sélection, et dans lequel chaque voie de sortie est associée à un bloc de commutation d'une succession de blocs (53₁,..., 53ₖ) de commutation, chaque bloc de commutation étant configuré pour alternativement : lorsqu'un bit de configuration donné dudit autre mot de configuration (CSW') adopte une valeur donnée adopter un état dans lequel sa voie de sortie (55₁,..., 55ₖ) associée est connectée à une sortie de sélection du sélecteur de colonnes à laquelle elle est associée parmi une succession de sorties de sélections et lorsque ledit bit de configuration donné dudit autre mot de configuration (CSW') adopte une valeur complémentaire de ladite valeur donné adopter un autre état dans lequel sa voie de sortie associée est déconnectée de cette sortie de sélection,
ledit étage de commande (6) étant en outre configuré pour commander les configurations respectives desdits blocs (56₁,..., 56ₖ) de commutation, par le biais dudit autre mot de configuration (CSW') de sorte qu'une valeur d'un bit (b'₁) dudit autre mot de configuration (CSW') détermine un état d'un premier bloc de commutation (56₂) tandis qu'une valeur d'un autre bit (b'₂) dudit autre mot de configuration détermine un état d'un deuxième bloc de commutation (56₃).

7. Dispositif (100) d'affichage d'images selon la revendication 5, dans lequel chaque registre à décalage (51₁,..., 51ₖ) dudit circuit de sélection (50D) est en outre associé à un élément de commutation d'une succession d'éléments de commutation (58₁,..., 58ₖ), chaque élément de commutation étant configuré pour : lorsqu'un bit donné dudit autre mot de configuration (CSW') adopte une valeur donnée, adopter un premier état dans lequel l'élément de commutation relie l'entrée du registre à décalage auquel il est associé à la sortie du registre à décalage auquel il est associé et pour lorsque le bit donné dudit autre mot de configuration (CSW') adopte une valeur complémentaire de ladite valeur donnée, adopter un deuxième état dans lequel l'entrée du registre à décalage auquel il est associé est déconnecté de la sortie du registre à décalage auquel il est associé, ledit étage de commande (6) étant configuré pour mettre lesdits éléments de commutation de ladite succession d'éléments de commutation dans l'un desdits premier état ou deuxième état en fonction des états respectifs de bits dudit autre mot de configuration (CSW'), de sorte qu'une valeur d'un bit (b'₂) dudit autre mot de configuration (CSW') détermine un état d'un élément de commutation (58'₃) de ladite succession d'éléments de commutation (58₁,..., 58ₖ), une valeur d'un autre bit de configuration (b'₃) dudit autre mot de configuration (CSW') détermine un état d'un autre élément de commutation (58'₄) de ladite succession d'éléments de commutation (58₁,..., 58ₖ).

8. Dispositif (100) d'affichage selon l'une des revendications 1 à 7, dans lequel ledit circuit de sélection (50A, 50B, 50C, 50D) appartient au contrôleur (5) de colonnes, et dans lequel le sélecteur (3) de lignes comprend un deuxième circuit de sélection (30) comportant une suite de voies de sorties (35₁,...,35ₖ) correspondant à différentes lignes de la matrice, le deuxième circuit de sélection (30) étant doté d'une suite de registres (31₁,...,31ₖ) à décalage et d'une suite de commutateurs (33₁,..., 33ₖ) commandée par au moins un second mot de configuration (LSW), chaque registre à décalage du deuxième circuit de sélection (30) étant associé à une voie de sortie de ladite suite de voies de sortie et à un commutateur de ladite suite de commutateurs,
le dispositif d'affichage comprenant en outre un deuxième étage (4) de commande doté d'au moins un autre registre mémoire (41) pour recevoir ledit autre mot de configuration (LSW), le deuxième étage (4) de commande étant configuré pour commander les configurations respectives de la suite de commutateurs (33₁,..., 33ₖ) du deuxième circuit de sélection (30) par le biais dudit second mot de configuration (LSW).

9. Procédé de gestions de données dans un dispositif d'affichage selon la revendication 8, comprenant, dans cet ordre, des étapes de :
- réception d'un ou plusieurs mots de configuration (CSW, CSW') respectivement par un ou plusieurs registre mémoire (61, 66) dudit étage (6) de commande et réception dudit second mot de configuration (LSW) par ledit autre registre mémoire (41) dudit deuxième étage (4) de commande,
- réception par ledit dispositif d'affichage de données de contrôle d'affichage de pixels correspondant à une première image,
- réception d'un ou plusieurs nouveaux mots de configuration (CSW, CSW') par lesdits un ou plusieurs registres (61, 66) dudit étage de commande et réception d'un nouveau second mot de configuration (LSW), par ledit autre registre (41) dudit deuxième étage de commande,
- la réception par le dispositif d'affichage de données de contrôle d'affichage de pixels correspondant à une deuxième image.

10. Procédé de gestions de données dans un dispositif d'affichage selon la revendication 8, comprenant, dans cet ordre, des étapes de :
- réception d'un ou plusieurs mots de configuration (CSW) respectivement par un ou plusieurs registres mémoires (61, 66) dudit étage (6) de commande et réception dudit second mot de configuration par ledit autre registre mémoire (41) dudit deuxième étage (4) de commande,
- réception par le dispositif d'affichage de données de contrôle d'affichage de pixels correspondant à une première ligne d'une première image,
- réception d'un ou plusieurs nouveaux mots de configuration (CSW, CSW') par lesdits un ou plusieurs registres mémoire (61) dudit étage (6) de commande,
- réception par le dispositif d'affichage de données de contrôle d'affichage de pixels correspondant à une deuxième ligne de la première image.

11. Système de réalité augmentée ou de réalité virtuelle comprenant un dispositif d'affichage selon l'une des revendications 1 à 8.

## Patentansprüche

1. Vorrichtung zur Anzeige von Bildern, umfassend eine Matrix von Pixeln, die derart angeordnet sind, dass sie mehrere Zeilen und mehrere Spalten von Pixeln bilden, wobei die Anzeigevorrichtung umfasst:
- einen Zeilenselektor (3), der mit den Zeilen der Matrix von Pixeln gekoppelt ist,
- einen Spaltencontroller (5), der mit den Spalten der Matrix von Pixeln gekoppelt ist,
wobei der Zeilenselektor (3) und/oder der Spaltencontroller (5) umfassen:
- eine Selektionsschaltung (30, 50A, 50B, 50C, 50D), umfassend eine Folge von Ausgangspfaden (35₁, ..., 35ₖ; 55₁, ..., 55ₖ) entsprechend verschiedenen Reihen der Matrix von Pixeln, wobei die Selektionsschaltung ferner eine Folge von Schieberegistern (31₁, ..., 31ₖ; 51₁, ..., 51ₖ) _{un1d} eine Folge von Schaltern (33₁, ..., 33ₖ; 53₁, ..., 53ₖ) umfasst, die durch wenigstens ein Konfigurationswort (LSW, CSW, CSW') gesteuert werden, wobei jedes Schieberegister einem Ausgangspfad der Selektionsschaltung und einem Schalter der Folge von Schaltern (33₁, ..., 33ₖ; 53₁, ..., 53ₖ) zugeordnet ist,
wobei ein gegebener Ausgangspfad (35₃, 55₃) der Selektionsschaltung mit einem Eingang eines Schieberegisters (31₄, 51₄) verbunden ist, das auf das Schieberegister (31₃, 51₃) folgt, dem der gegebene Ausgangspfad (35₃, 55₃) zugeordnet ist,
wobei dieser gegebene Ausgangspfad (35₃, 55₃) mit einem Ausgang des Schieberegisters verbunden ist, dem er zugeordnet ist, und von einem vorhergehenden Ausgangspfad (35₂, 55₂) der Folge von Ausgangspfaden getrennt ist, wenn der gegebene Schalter (33₂, 53₂), dem dieser gegebene Ausgangspfad zugeordnet ist, in eine erste Konfiguration gebracht ist, wobei der gegebene Ausgangspfad (35₃, 55₃) mit dem vorhergehenden Ausgangspfad (35₂, 55₂) der Folge von Ausgangspfaden verbunden ist und von dem Ausgang des Schieberegisters getrennt ist, dem der Ausgangspfad zugeordnet ist, wenn der gegebene Schalter (33₃, 53₃) in eine zweite Konfiguration gebracht ist, wobei die Vorrichtung ferner umfasst:
- eine Steuerstufe (4, 6) zum Steuern der jeweiligen Konfigurationen der Folge von Schaltern (33₁, ..., 33ₖ; 53₁, ..., 53ₖ) der Selektionsschaltung (30, 50A, 50B, 50C, 50D), wobei die Steuerstufe (4, 6) mit wenigstens einem Speicherregister (41, 61, 66) zum Empfangen wenigstens eines Konfigurationsworts (LSW, CSW, CSW') ausgestattet und dazu konfiguriert ist, die Schalter (33₁, ..., 33ₖ; 53₁, ..., 53ₖ) der Folge von Schaltern jeweils in eine von der ersten Konfiguration oder der zweiten Konfiguration als Funktion der jeweiligen Bitzustände (a₀, ..., aₖ₋₁; b₀, ..., bₖ₋₁) des Konfigurationsworts (LSW, CSW, CSW') zu bringen, derart, dass eine Konfiguration eines ersten Schalters von einem Wert eines ersten Bits des Konfigurationsworts abhängt, wobei eine Konfiguration eines zweiten Schalters von einem Wert eines zweiten Bits des Konfigurationsworts abhängt.

2. Anzeigevorrichtung (100) nach Anspruch 1, bei der die Selektionsschaltung (50A) zum Spaltencontroller (5) gehört, wobei der Spaltencontroller einen Spaltenselektor (500) umfasst, der mit der Selektionsschaltung (50A) ausgestattet ist, und in dem ein Aktivierungstoken dazu ausgelegt ist, am Eingang (E) der Folge von Registern (51₁, ..., 51ₖ) emittiert zu werden und sich in dieser Folge auszubreiten, um sequenziell einen Ausgangspfad zu aktivieren oder gleichzeitig eine Gruppe von miteinander verbundenen Ausgangspfaden, wobei der Spaltencontroller (5) ferner am Ausgang des Spaltenselektors Folgendes umfasst: einen Speicher (59), wobei der Speicher (59) dazu konfiguriert ist, eine Sequenz von Daten zur Steuerung der Pixelanzeige zu empfangen, und mit einer Mehrzahl von Speicherplätzen ausgestattet ist, die jeweils einer Spalte von den Spalten der Matrix zugeordnet sind, wobei jeder Speicherplatz selbst wiederum einem Ausgangspfad (53₁, ..., 53ₖ) der Selektionsschaltung (50) zugeordnet ist, der, wenn er aktiviert ist, anschließend an den Empfang von Daten zur Anzeigesteuerung am Eingang des Speichers eine Speicherung dieser Daten verursacht in dem oder den Speicherplatz/Speicherplätzen, der/die jeweils dem oder den aktivierten Ausgangspfaden (53₁, ..., 53ₖ) zugeordnet ist/sind.

3. Anzeigevorrichtung (100) nach Anspruch 1, bei der die Selektionsschaltung (50B) zum Spaltencontroller (5) gehört, wobei die Selektionsschaltung (50B) dazu konfiguriert ist, Daten zur Steuerung der Pixelanzeige zu empfangen, die auf N Bit (mit N≥1) kodiert sind, wobei der gegebene Ausgangspfad (55₃) der Folge von Ausgangspfaden (55₁, ..., 55ₖ) ein Ausgangspfad eines Bits von Daten zur Steuerung der Pixelanzeige ist.

4. Anzeigevorrichtung (100) nach Anspruch 3, bei der die Selektionsschaltung (50B) dazu konfiguriert ist, Daten zur Steuerung der Pixelanzeige zu empfangen, die auf N Bit (mit N>2) kodiert sind, wobei die Selektionsschaltung (50B) derart konfiguriert ist, dass ein erstes Datenbit zur Steuerung der Pixelanzeige auf einem ersten Eingang (E_bit1) der Selektionsschaltung (50B) emittiert wird, entsprechend einem Eingang der Folge (51₁, ..., 51ₖ) von Schieberegistern,
wobei die Selektionsschaltung (50B) ferner parallel zu der Folge von Schieberegistern (51₁, ..., 51ₖ) wenigstens eine zweite Folge von Schieberegistern (51₂₁, ..., 51₂ₖ) umfasst, wobei jedes Schieberegister der zweiten Folge einem Selektionsausgangspfad einer zweiten Folge von Ausgangspfaden (55₂₁, ..., 55₂ₖ) und einem Schalter einer zweiten Folge von Schaltern (53₂₁, ..., 53₂ₖ) zugeordnet ist, wobei die Selektionsschaltung (50B) derart konfiguriert ist, dass ein zweites Datenbit zur Steuerung der Pixelanzeige auf einem zweiten Eingang (E_bit2) der Selektionsschaltung (50B) entsprechend einem Eingang (E_bit2) der zweiten Folge (51₂₁, ..., 51₂ₖ) von Schieberegistern emittiert wird,
wobei der gegebene Ausgangspfad (55₃) der Folge von Ausgangspfaden (55₁, ..., 55ₖ) und ein anderer Ausgangspfad (55₂₃) der zweiten Folge von Ausgangspfaden (55₂₁, ..., 55₂ₖ) Ausgangspfade eines Datenbits zur Steuerung der Pixelanzahl beziehungsweise eines anderen Bits der gleichen Daten zur Steuerung der Anzeige des Pixels mit Bestimmung für eine Spalte der Matrix sind, wobei der andere Ausgangspfad (55₂₃) einem Schalter (53₂₃) der zweiten Folge von Schaltern zugeordnet ist, der durch ein und dasselbe Konfigurationsbit (b₂) des Konfigurationsworts (CSW) gesteuert wird wie der gegebene Schalter (53₂).

5. Anzeigevorrichtung (100) nach Anspruch 1, bei der die Selektionsschaltung (50B) zum Spaltencontroller (5) gehört, und bei der die Konfigurationssteuerstufe (6) dazu konfiguriert ist, wenigstens ein anderes Konfigurationswort (CSW') zu empfangen, wobei die Konfigurationssteuerstufe (6) mit einer Folge von logischen Ports (67₁, ..., 67ₖ) ausgestattet ist, deren jeweilige Ausgänge die jeweiligen Konfigurationen der Schalter (53₁, ..., 53ₖ) der Folge von Schaltern steuern, und derart, dass die jeweiligen Konfigurationen der Schalter (53₁, ..., 53ₖ) das Ergebnis einer logischen Funktion, insbesondere einer ODER-Funktion oder einer NICHT-UND-Funktion, zwischen einem Konfigurationsbit (b₀, ..., bₖ) des Konfigurationsworts (CSW) und einem Konfigurationsbit (b'₀, ..., b'ₖ) des anderen Konfigurationsworts (CSW') sind.

6. Anzeigevorrichtung (100) nach Anspruch 5, bei der die Selektionsschaltung (50C) zum Spaltencontroller (5) gehört, wobei der Spaltencontroller (5) einen Spaltenselektor (500) umfasst, der eine Folge von Selektionsausgängen (57₁, ..., 57ₖ) umfasst, wobei der Spaltenselektor mit der Selektionsschaltung (50C) ausgestattet ist, und bei der jeder Ausgangspfad einem Schaltblock einer Folge von Schaltblöcken (53₁, ..., 53ₖ) zugeordnet ist, wobei jeder Schaltblock zu Folgendem alternativ konfiguriert ist: wenn ein gegebenes Konfigurationsbit des anderen Konfigurationsworts (CSW') einen gegebenen Wert annimmt, einen Zustand anzunehmen, in dem sein zugeordneter Ausgangspfad (55₁, ..., 57ₖ) mit einem Selektionsausgang des Spaltenselektors verbunden ist, dem er zugeordnet ist, aus einer Folge von Selektionsausgängen, und wenn das gegebene Konfigurationsbit des anderen Konfigurationsworts (CSW') einen komplementären Wert des gegebenen Werts annimmt, einen anderen Zustand anzunehmen, in dem sein zugeordneter Ausgangspfad von diesem Selektionsausgang getrennt ist,
wobei die Steuerstufe (6) ferner dazu konfiguriert ist, die jeweiligen Konfigurationen der Schaltblöcke (56₁, ..., 56ₖ) mittels des anderen Konfigurationsworts (CSW') derart zu steuern, dass ein Wert eines Bits (b'₁) des anderen Konfigurationsworts (CSW') einen Zustand eines ersten Schaltblocks (56₂) bestimmt, wohingegen ein Wert eines anderen Bits (b'₂) des anderen Konfigurationsworts einen Zustand eines zweiten Schaltblocks (56₃) bestimmt.

7. Anzeigevorrichtung (100) zur Anzeige von Bildern nach Anspruch 5, bei der jedes Schieberegister (51₁, ..., 51ₖ) der Selektionsschaltung (50D) ferner einem Schaltelement einer Folge von Schaltelementen (58₁, ..., 58ₖ) zugeordnet ist, wobei jedes Schaltelement zu Folgendem konfiguriert ist: wenn ein gegebenes Bit des anderen Konfigurationsworts (CSW') einen gegebenen Wert annimmt, einen ersten Zustand anzunehmen, in dem das Schaltelement den Eingang des Schieberegisters, dem es zugeordnet ist, mit dem Ausgang des Schieberegisters verbindet, dem es zugeordnet ist, und wenn das gegebene Bit des anderen Konfigurationsworts (CSW') einen komplementären Wert des gegebenen Werts annimmt, einen zweiten Zustand anzunehmen, in dem der Eingang des Schieberegisters, dem es zugeordnet ist, von dem Ausgang des Schieberegisters getrennt ist, dem es zugeordnet ist, wobei die Steuerstufe (6) dazu konfiguriert ist, die Schaltelemente der Folge von Schaltelementen in einen von dem ersten Zustand oder dem zweiten Zustand zu bringen als Funktion der jeweiligen Zustände von Bits des anderen Konfigurationsworts (CSW'), derart, dass ein Wert eines Bits (b'₂) des anderen Konfigurationsworts (CSW) einen Zustand eines Schaltelements (58'₃) der Folge von Schaltelementen (58₁, ..., 58ₖ) bestimmt, ein Wert eines anderen Konfigurationsbits (b'₃) des anderen Konfigurationsworts (CSW') einen Zustand eines anderen Schaltelements (58'₄) der Folge von Schaltelementen (58₁, ..., 58ₖ) bestimmt.

8. Anzeigevorrichtung (100) nach einem der Ansprüche 1 bis 7, bei der die Selektionsschaltung (50A, 50B, 50C, 50D) zum Spaltencontroller (5) gehört, und bei der der Zeilenselektor (3) eine zweite Selektionsschaltung (30) umfasst, umfassend eine Folge von Ausgangspfaden (35₁, ..., 35ₖ) entsprechend verschiedenen Zeilen der Matrix, wobei die zweite Selektionsschaltung (30) mit einer Folge von Schieberegistern (31₁, ..., 31ₖ) und einer Folge von Schaltern (33₁, ..., 33ₖ) ausgestattet ist, die durch wenigstens ein zweites Konfigurationswort (LSW) gesteuert werden, wobei jedes Schieberegister der zweiten Selektionsschaltung (30) einem Ausgangspfad der Folge von Ausgangspfaden und einem Schalter der Folge von Schaltern zugeordnet ist,
wobei die Anzeigevorrichtung ferner eine zweite Steuerstufe (4) umfasst, die mit wenigstens einen anderen Speicherregister (41) zum Empfangen des anderen Konfigurationsworts (LSW) ausgestattet ist, wobei die zweite Steuerstufe (4) dazu konfiguriert ist, die jeweiligen Konfigurationen der Folge von Schaltern (33₁, ..., 33ₖ) der zweiten Selektionsschaltung (30) mittels des zweiten Konfigurationsworts (LSW) zu steuern.

9. Verfahren zur Verwaltung von Daten in einer Anzeigevorrichtung nach Anspruch 8, umfassend, in dieser Reihenfolge, die folgenden Schritte:
- Empfangen von ein oder mehreren Konfigurationsworten (CSW, CSW') jeweils durch ein oder mehrere Speicherregister (61, 66) der Steuerstufe (6), und Empfangen des zweiten Konfigurationsworts (LSW) durch das andere Speicherregister (41) der zweiten Steuerstufe (4),
- Empfangen, durch die Anzeigevorrichtung, von Daten zur Steuerung der Anzeige von Pixeln entsprechend einem ersten Bild,
- Empfangen von einem oder mehreren neuen Konfigurationswörtern (CSW, CSW') durch die ein oder mehreren Register (61, 66) der Steuerstufe, und Empfangen eines neuen zweiten Konfigurationsworts (LSW) durch das andere Register (41) der zweiten Steuerstufe,
- Empfangen, durch die Anzeigevorrichtung, von Daten zur Steuerung der Anzeige von Pixeln entsprechend einem zweiten Bild.

10. Verfahren zur Verwaltung von Daten in einer Anzeigevorrichtung nach Anspruch 8, umfassend, in dieser Reihenfolge, die folgenden Schritte:
- Empfangen von ein oder mehreren Konfigurationswörtern (CSW) jeweils durch ein oder mehrere Speicherregister (61, 66) der Steuerstufe (6), und Empfangen des zweiten Konfigurationsworts durch das andere Speicherregister (41) der zweiten Steuerstufe (4),
- Empfangen, durch die Anzeigevorrichtung, von Daten zur Steuerung der Anzeige von Pixeln entsprechend einer ersten Zeile eines ersten Bilds,
- Empfangen von einem oder mehreren neuen Konfigurationswörtern (CSW, CSW') durch die ein mehreren Speicherregister (61) der Steuerstufe (6),
- Empfangen, durch die Anzeigevorrichtung, von Daten zur Steuerung der Anzeige von Pixeln entsprechend einer zweiten Zeile des ersten Bilds.

11. System für Augmented Reality oder für Virtual Reality, umfassend eine Anzeigevorrichtung nach einem der Ansprüche 1 bis 8.

## Claims

1. A device for displaying images comprising a matrix of pixels arranged by forming a plurality of lines and a plurality of columns of pixels, the display device comprising:
- a line selector (3), coupled with the lines of the matrix of pixels,
- a column controller (5) coupled with the columns of the matrix of pixels,
the line selector (3) and/or the column controller (5) comprising:
- a selection circuit (30, 50A, 50B, 50C, 50D) including a succession of output channels (35₁,...,35ₖ; 55₁,...,55ₖ,) corresponding to various rows of said matrix of pixels, said selection circuit further comprising a succession of shift registers (31₁,...,31ₖ ; 51₁,...,51ₖ) and a succession of switches (33₁,..., 33ₖ ; 53₁,..., 53ₖ) controlled by at least one configuration word (LSW, CSW, CSW'), each shift register being associated with an output channel of said selection circuit and with a switch of said succession of switches(33₁,..., 33ₖ ; 53₁,..., 53ₖ), a given output channel (35₃, 55₃) of said selection circuit being capable of being connected to an input of a shift register (31₄, 51₄) following the shift register (31₃, 51₃) with which the given output channel (35₃, 55₃) is associated, this given output channel (35₃, 55₃) being connected to an output of the shift register with which it is associated and being disconnected from a preceding output channel of said succession of output channels when a given switch (33₂, 53₂) with which this given output channel is associated is placed in a first configuration, the given output channel (35₃, 55₃) being connected to a preceding output channel (35₂, 55₂) of said succession of output channels and being disconnected from said output of the shift register with which said output channel is associated when the given switch is placed in a second configuration, the device further comprising:
- a control stage (4, 6), for controlling the respective configurations of the succession of switches (33₁,..., 33ₖ ; 53₁,..., 53ₖ) of said selection circuit (30, 50A, 50B, 50C, 50D), the control stage (4, 6) being provided with at least one memory register (41, 61, 66) for receiving at least said one configuration word(LSW, CSW, CSW') and being configured to place the switches (33₁,..., 33ₖ ; 53₁,..., 53ₖ) of said succession of switches respectively in one of said first configuration or second configuration according to the respective states of bits (a₀,...,aₖ₋₁ ; b₀,...,bₖ₋₁) of said at least one configuration word, so that a configuration of a first switch depends on a value of a first bit of said configuration word (LSW, CSW, CSW'), a configuration of a second switch depending on a value of a second bit of said configuration word.

2. The display device(100) according to claim 1, wherein said selection circuit (50A) belongs to the column controller (5), the column controller (5) comprising a column selector (500) provided with said selection circuit (50A) and wherein an activation token is capable of being emitted at the input (E) of said succession of registers (51₁,...,51ₖ) and of propagating in this succession to sequentially activate an output channel or concomitantly a group of output channels connected to each other, the column controller (5) further comprising, at the output of said column selector: a memory (59), said memory (59) being configured to receive a sequence of data for controlling pixel display and being provided with a plurality of memory spaces each associated with one column out of said columns of the matrix, each memory space being itself associated with an output channel (55₁,..., 55ₖ) of said selection circuit (50A) which, when it is activated, causes, consecutively to the reception of a piece of data for controlling display at the input of the memory, a memorization of this piece of data in the memory space(s) respectively associated with the activated output channel(s) (53₁,..., 53ₖ).

3. The display device (100) according to claim 1, wherein said selection circuit (50B) belongs to the column controller (5), said selection circuit (50B) being configured to receive said pixel data for controlling pixel display encoded over N bits (with N≥1), said given output channel (55₃) of said succession of output channels (55₁,..., 55ₖ) being an output channel of a bit of a piece of data for controlling pixel display.

4. The display device (100) according to claim 3, wherein the selection circuit (50B) is configured to receive data for controlling pixel display encoded over N bits (with N >2), said selection circuit (50B) being configured so that a first bit of a piece of data for controlling pixel display is emitted over a first input (E_bit1) of said selection circuit corresponding to an input of said succession of shift registers (51₁,...,51ₖ),
said selection circuit further comprising, in parallel to said succession of shift registers (51₁,...,51ₖ), at least one second succession of shift registers (51₂₁,...,51₂ₖ), each shift register of said second succession being associated with an output channel for selection of a second succession of output channels (55₂₁, ..._{.}55₂ₖ) and with a switch of a second succession of switches (53₂₁,...,53₂ₖ), said selection circuit (50B) being configured so that a second bit of a piece of data for controlling pixel display is emitted over a second input (E_bit2) of said selection circuit (50B) corresponding to an input (E_bit2) of said second succession of shift registers (51₂₁,...,51₂ₖ),
said given output channel (55₃) of said succession of output channels (55₁,...,55ₖ) and another output channel (55₂₃) of the second succession of output channels (55₂₁, ..._{.}55₂ₖ) being channels for output respectively of a bit of a piece of data for controlling pixel display and of another bit of said same piece of data for controlling display of said pixel to a column of the matrix, said another output channel (55₂₃) being associated with a switch (53₂₃) of said second succession of switches controlled by the same configuration bit (b₂) of said configuration word (CSW) as said given switch (53₂).

5. The display device (100) according to claim 1, wherein said selection circuit (50B) belongs to the column controller (5) and wherein said stage (6) for controlling configuration is configured to receive at least one other configuration word (CSW'), said stage for controlling configuration being provided with a series of logic gates (67₁,...67ₖ), the respective outputs of which control the respective configurations of said switches of said succession of switches (53₁,..., 53ₖ) and so that the respective configurations of said switches are the result of a logical function, in particular an OR function or a NAND function, between a configuration bit (b₀,...,bₖ) of said configuration word (CSW) and a configuration bit (b'₀,...,b'ₖ) of said other configuration word (CSW').

6. The display device (100) according to claim 5, wherein said selection circuit (50C) belongs to the column controller (5), the column controller (5) comprising a column selector (500) including a succession of selection outputs (57₁,..., 57ₖ), the column selector (500) being provided with said selection circuit (50C), and wherein each output channel is associated with a switching block of a succession of switching blocks (53₁,..., 53ₖ), each switching block being configured to alternatingly: when a given configuration bit of said other configuration word (CSW') adopts a given value, adopt a state in which its associated output channel (55₁,..., 55ₖ) is connected to a selection output of the column selector with which it is associated out of a succession of selection outputs and when said given configuration bit of said other configuration word adopts a complementary value of said given value adopt another state in which its associated output channel is disconnected from this selection output,
said control stage (6) being further configured to control the respective configurations of said switching blocks (56₁,..., 56ₖ), via said other configuration word so that a value of a bit (b'₁) of said other configuration word (CSW') determines a state of a first switching block (56₂) while a value of another bit (b'₂) of said other configuration word determines a state of a second switching block (56₃).

7. The display (100) for displaying images according to claim 5, wherein each offset register (51₁,..., 51ₖ) of said selection circuit (50D) is further associated with a switching element of a succession of switching elements (58₁,..., 58ₖ), each switching element being configured to:
when a given bit of said other configuration word (CSW') adopts a given value, adopt a first state in which the switching element connects the input of the shift register with which it is associated to the output of the shift register with which it is associated and to
when the given bit of said other configuration word (CSW') adopts a complementary value of said given value, adopt a second state in which the input of the shift register with which it is associated is disconnected from the output of the shift register with which it is associated, said control stage (6) being configured to place said switching elements of said succession of switching elements in one of said first state or second state according to the respective states of bits of said other configuration word (CSW'), so that a value of a bit (b'₂) of said other configuration word (CSW') determines a state of a switching element (58'₃) of said succession of switching elements (58₁,..., 58ₖ), a value of another configuration bit (b'₃) of said other configuration word (CSW') determines a state of another switching element (58'₄) of said succession of switching elements (58₁,..., 58ₖ).

8. The display device (100) according to any of the claims 1 to 7, wherein said selection circuit (50A, 50B, 50C, 50D) belongs to the column controller (5), and wherein the line selector (3) comprises a second selection circuit (30) including a series of output channels (35₁,...,35ₖ) corresponding to various lines of the matrix, the second selection circuit being provided with a series of shift registers (31₁,...,31ₖ) and with a series of switches (33₁,...,33ₖ) controlled by at least one second configuration word (LSW), each shift register of the second selection circuit (30) being associated with an output channel of said series of output channels and with a switch of said series of switches,
the display device further comprising a second control stage (4) provided with at least one other memory register (41) for receiving said other configuration word (LSW), the second control stage (4) being configured to control the respective configurations of the series of switches (33₁,..., 33ₖ) of the second selection circuit (30) via said second configuration word (LSW).

9. A method for managing data in a display device according to claim 8, comprising, in this order, the steps of:
- reception of one or more configuration words (CSW) respectively by one or more memory registers (61, 66) of said control stage (6) and reception of said second configuration word (LSW) by said other memory register (41) of said second control stage (4),
- reception by said display device of data for controlling pixel display corresponding to a first image,
- reception of one or more new configuration words (CSW, CSW') by said one or more registers (61, 66) of said control stage (6) and reception of a new second configuration word (LSW), by said other register of said second control stage (41),
- the reception by the display device of data for controlling pixel display corresponding to a second image.

10. The method for managing data in a display device (100) according to claim 8, comprising, in this order, the steps of:
- reception of one or more configuration words (CSW) respectively by one or more memory registers (61,62) of said control stage (6) and reception of said second configuration word (41) by said other memory register of said second control stage (4),
- reception by the display device of data for controlling pixel display corresponding to a first line of a first image,
- reception of one or more new configuration words (CSW, CSW') by said one or more memory registers (61) of said control stage (6),
- reception by the display device of data for controlling pixel display corresponding to a second line of the first image.

11. A system for augmented reality or for virtual reality comprising a display device according to any of the claims 1 to 8.
